# EUROPEAN PATENT APPLICATION

(11) **EP 1 209 958 A2**
(43) Date of publication of application: **29.05.2002**
(21) Application number: 01126704.4
(22) Date of filing: 08.11.2001
(51) Int. Cl.: H05K 3/24, C23C 18/42

(54) **Laminated structure for electronic equipment and method of electroless gold plating**

(30) Priority: 24.11.2000 JP 2000403023
(71) Applicant: Millennium Gate Technology Co., Ltd., Higashiosaka-shi, Osaka (JP)
(72) Inventor: Takeuchi, Isamu, Millenium Gate Technology Co.,LTD, Higashiosaka-shi, Osaka (JP); Morimitsu, Masaaki c/oMillenium Gate Techn. CO LTD, Higashiosaka-shi, Osaka (JP)
(74) Representative: Müller - Hoffmann & Partner

(57) **Abstract**

A laminated structure for electronic equipment includes a printed circuit board (11) having copper foil (12), an undercoat plating layer (13) made of tin or silver, formed on the printed circuit board (11), and a gold plating layer (14) formed on the undercoat plating layer (13) by electroless plating. Tin or silver is a metal which acts as an anticatalyst in electroless plating. After formation of the undercoat plating layer (13), the printed circuit board (11) is dipped in catalyst-applying treating liquid to inhibit the anticatalyst.

## Description

### BACKGROUND OF THE INVENTION

### Field of the Invention

The present invention relates to a laminated structure for electronic equipment having a good soldering performance and a method of manufacturing the same, and to a method of electroless gold plating for improving a soldering performance.

### Description of the Background Art

Since gold is not oxidized and in addition has a small electric contact resistance, it is widely used as a plating layer for various kinds of connectors and terminals of integrated circuits in the field of electronic industry. More specifically, a gold coating is formed by electroless plating on the surface of a printed circuit board made of synthetic resin, on which a large scale integrated circuit chip is mounted. The electroless gold plating is intended for the improvement in a soldering performance and a contact function, which is required as electronic equipment is reduced in size and weight. Recently, such a printed circuit board is widely used in electronic equipment, for example, mobile phones, digital cameras and the like, that requires a high packaging density.

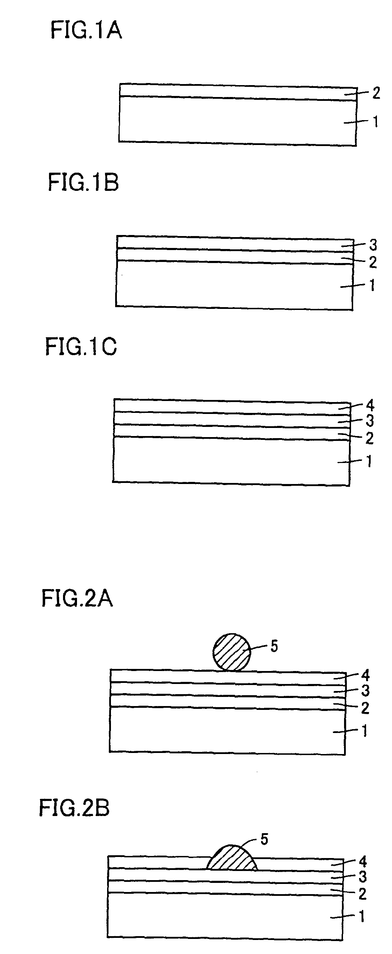

Figs. 1A, 1B and 1C show in order the process steps of conventional electroless gold plating on a printed circuit board.

As shown in Fig. 1A, the printed circuit board has an insulating substrate 1 made of epoxy resin or the like, and copper foil 2 laminated thereon to serve as a circuit conductor. As shown in Fig. 1B, a nickel plating layer 3 which will serve as an undercoat is formed on this printed circuit board by electroless plating. Nickel plating layer 3 has a thickness of about 2-5 µm, and is intended to prevent diffusion between copper foil 2 and a subsequently formed gold coating and to increase the strength of the printed circuit board.

Prior art that discloses formation of a nickel plating layer on a printed circuit board includes Japanese Patent Laying-Open Nos. 3-39488 and 8-181432.

As shown in Fig. 1C, gold coating 4 is formed on nickel plating layer 3 by electroless plating. Thus, a laminated structure for electronic equipment results.

In the step of mounting an electronic component such as a chip component and the like on the gold-plated, printed circuit board, a reflow or flow type soldering is performed. Generally, soldering requires a heating temperature of about 220- about 250 °C and a duration time of 10 seconds or less.

When soldering is performed on a conventional laminated structure for electronic equipment, the following problem arises. Description will be made with reference to Figs. 2A and 2B.

Fig. 2A shows that a solder ball 5 rests on gold coating 4 of the laminated structure for electronic equipment. Since gold has a good affinity with solder that includes tin and lead as main components, it tends to easily melt in solder and sometimes forms a fragile intermetallic compound. Thus, as shown in Fig. 2B, in a soldering process, gold coating 4 directly in contact with solder ball 5 penetrates into solder instanteneously. As a result, solder passes through gold coating 4 to adhere onto the undercoat nickel layer 3. A bad affinity of nickel with solder, however, causes a problem of the reliability in the soldering strength between nickel layer 3 and solder ball 5.

As high-density and compact electronic equipment is particularly vulnerable to colliding with other components and falling, the shock at the time of collision and fall may cause disconnection of wiring and the equipment may become disfunctional. Once electronic equipment is defected, the repair thereof is very difficult.

Mounting of an electronic component on a printed circuit board must cope with variable fashions (toward reduction in size) including a discrete type, a chip component type, a BGA (Ball Grid Array) type, while attaining a smallest possible soldering area. Therefore, in the conventional method of electroless gold plating in which nickel layer 3 is formed as an undercoat plating layer, a drawback in the reliability of soldering strength has been attracting attention.

Since a component which is soldered on a printed circuit board is adhered on nickel plating layer 3 having a bad affinity, joint strength is unreliable at the time of a shock, vibration and temperature change. For improvements, plating of gold, silver, tin, etc. directly on copper foil 2 of the printed circuit board can be considered in place of forming a nickel layer. This can improve the soldering strength but causes whisker, corrosion of copper foil 2 resulting from pin-hole and the like, and therefore cannot achieve an improvement in a contact function.

In the astronautical related field, when a gold-plated component is to be soldered, a method is employed in which that part of gold plating which is to be soldered is scraped off before soldering. For example, in a soldering process of electronic equipment in NASA, such a procedure is strictly followed. In the non-governmental field, however, it is essentially impossible to employ such a process requiring a delicate skill and labor and an effort, in an economic point of view.

### SUMMARY OF THE INVENTION

An object of the present invention is to provide a laminated structure for electronic equipment having reliable soldering strength.

Another object of the present invention is to provide a laminated structure for electronic equipment capable of preventing whisker and corrosion of copper foil resulting from pin-hole and the like, to improve a contact function.

Yet another object of the present invention is to provide a method of manufacturing the above noted laminated structure for electronic equipment.

A further object of the present invention is to provide a method of electroless gold plating for attaining reliable soldering strength with reasonable cost.

A laminated structure for electronic equipment in accordance with an aspect of the present invention includes: a substrate having a main surface; an undercoat plating layer made of a material selected from the group consisting of tin, silver, cadmium, lead, zinc and bismuth and formed on the main surface of the substrate; and a gold plating layer formed on the undercoat plating layer.

Any of tin, silver, cadmium, lead, zinc and bismuth has a good affinity with solder, and thus even though solder passes through the gold plating layer to adhere fixedly onto the undercoat plating layer, the soldering strength therebetween can be well maintained. This contributes to the stabilization and improvement in the quality of soldering in case of high density packaging involved in the reduction in size and weight of a printed circuit board and the other various kinds of electronic equipment. Furthermore, since a thin gold compound is formed between the undercoat plating layer made of tin, silver, cadmium, lead, zinc or bismuth and the gold plating layer, the occurrence of whisker and the corrosion of the copper foil resulting from pin-hole can be prevented, thereby improving a contact function.

The substrate, for example, is a printed circuit board having copper foil on its surface. The other example includes an electronic component such as a chip component.

A laminated structure for electronic equipment in accordance with another aspect of the present invention includes: a substrate having a main surface; an undercoat plating layer made of a metal acting as an anticatalyst in electroless plating and formed on the main surface of the substrate; and a gold coating formed on the undercoat plating layer by electroless plating. A metal as an anticatalyst is selected, for example, from the group consisting of tin, silver, cadmium, lead, zinc and bismuth.

A method of manufacturing a laminated structure for electronic equipment in accordance with an aspect of the present invention includes the steps of: forming a plating layer serving as an undercoat on the substrate, using a metal selected from the group consisting of tin, silver, cadmium, lead, zinc and bismuth; and forming a gold coating by electroless plating on the undercoat plating layer. The metal forming an undercoat plating layer functions as an anticatalyst in the electroless plating.

A method of electroless gold plating in accordance with an aspect of the present invention includes the steps of: forming a plating layer serving as an undercoat on a substrate, using tin or silver; and forming a gold coating on the undercoat plating layer by electroless plating. The substrate is, for example, a printed circuit board having copper foil on its surface, and the undercoat plating layer is formed on the copper foil.

Preferably, the method further includes the step of dipping the substrate in catalyst-applying treating liquid after forming the undercoat plating layer. The step of forming the gold coating is performed after the step of dipping. The catalyst-applying treating liquid includes for example palladium chloride and hydrochloric acid.

A method of electroless gold plating in accordance with another aspect of the present invention includes the steps of: forming a plating layer serving as an undercoat on a substrate, using a metal as an anticatalyst selected from the group consisting of cadmium, lead, zinc and bismuth; and forming a gold coating on the undercoat plating layer by electroless plating.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Figs. 1A, 1B, and 1C show in order the steps of a conventional method of electroless gold plating.
Figs. 2A and 2B show a conventional laminated structure for electronic equipment in a plating step.
Figs. 3A, 3B and 3C show in order a series of steps of a method of electroless gold plating in accordance with the present invention.

### DESCRIPTION OF THE PREFERRED EMBODIMENTS

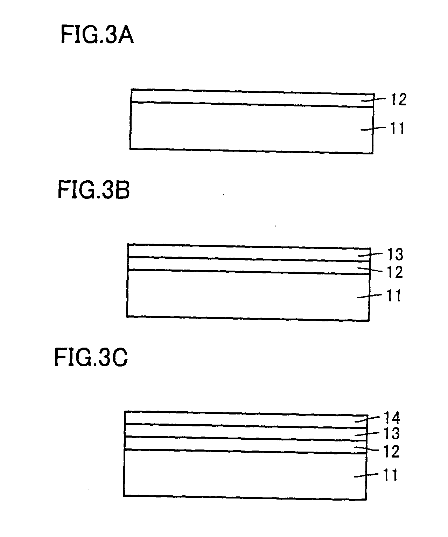

Referring to Figs. 3A, 3B and 3C, the steps of a method of obtaining a laminated structure for electronic equipment will be described.

First, as shown in Fig. 3A, a substrate to be subjected to plating is prepared. In the embodiment as shown, a printed circuit board 11 is used as a substrate. Printed circuit board 11 is provided with copper foil 12 on its surface.

As shown in Fig. 3B, tin or silver plating layer 13 to serve as an undercoat is formed, for example by electroless plating, on copper foil 12 of printed circuit board 11.

Then, as shown in Fig. 3C, a gold coating 14 is formed by electroless plating on undercoat plating layer 13. In electroless plating for printed circuit board 11, with only a tin or silver undercoat, undesirable migration or whisker could happen and moreover corrosion resistance and contact characteristics will be unsatisfactory. Therefore, it is necessary to form gold coating 14 on undercoat plating layer 13.

When electroless gold plating is performed on undercoat plating layer 13 formed of tin or silver by electroless plating, a difference in ionization and anticatalyst may result in insufficient deposition of a glossy gold coating layer. In order to avoid this problem, it is preferable to dip printed circuit board 11 in catalyst-applying treating liquid after forming undercoat plating layer 13.

Generally, tin or silver is superior in soldering characteristics but acts as an anticatalyst in electroless plating. Therefore, it is considered difficult to perform plating on these metals, with the result that they have not been utilized industrially. The inventors of the present invention made it possible to apply a gold coating by electroless plating on these metals, by dipping a substrate having undercoat plating layer 13 made of tin or silver into the catalyst-applying treating liquid to inhibit an anticatalyst.

When soldering is performed on the laminated structure for electronic equipment resulting through the above noted steps, a solder ball passes through gold coating 14 to fixedly adhere onto undercoat plating layer 13 made of tin or silver. Since tin or silver has a good affinity with solder, the soldering strength therebetween can be well maintained. Furthermore, since a thin gold compound is formed between undercoat plating layer 13 and gold coating 14, the occurrence of whisker or the corrosion of copper foil 12 resulting from pin-hole can be prevented, thereby improving a contact function.

A substrate subjected to plating is not limited to a printed circuit board, and, for example, a chip component or various kinds of other electronic components may be used. Furthermore, formation of the undercoat plating layer is not limited to electroless plating, and, for example, electroplating may be employed.

Tin or silver is a metal which acts as an anticatalyst in electroless plating. Similar metals include cadmium, lead, zinc and bismuth, which may be used as an undercoat plating layer in place of tin or silver. There is no significant difference in soldering characteristics among tin, silver, cadmium, lead, zinc and bismuth. Considering the toxicity for human being, tin and silver is preferable among the above listed anticatalyst metals.

### (Experimental Example)

Electroless gold plating was performed on a printed circuit board in the following procedure.
(1) A printed circuit board having a patterned copper foil on its surface was dipped in alkalescent degreasing liquid for three minutes for degreasing treatment.
(2) The printed circuit board was left in flowing water for one minute for washing.
(3) A tin plating layer was formed on the printed circuit board by electroless plating at a temperature of 40 °C for 30 minutes. The thickness of the tin plating layer was 1.5 µm.
(4) The printed circuit board was washed with water.
(5) The printed circuit board was dipped in catalyst-applying treating liquid containing 2g/liter of palladium chloride and 150g/liter of hydrochloric acid for three minutes.
(6) The printed circuit board was washed with water for one minute.
(7) A gold plating layer was formed on the printed circuit board by electroless plating at a temperature of 70 °C for 10 minutes. The thickness of the gold plating layer was 0.05 µm.
(8) The printed circuit board was washed with water.
(9) The printed circuit board was dried by heated air at 60 °C.

In addition, in place of tin in the above step (3), a silver plating layer was formed by electroless plating under the same condition, followed by the same subsequent processes.

In order to confirm the plating characteristics of the printed circuit board obtained through the above steps, a printed circuit board having a conventional nickel plating layer as an undercoat was used as a comparative example to observe the degree of solder spreading. Specifically, 0.5 g solder containing flux was applied on the printed circuit board using solder bath at 260 °C and then confirmed in the degree of the spreading.

The area of solder spreading when a substrate with a tin plating layer as an undercoat was soldered under the above condition for 60 seconds is assumed to be 100, and the areas of solder spreading were compared with undercoat metals and time for soldering changed variously. The result was as shown in Table 1.

**Table 1**

| | | | |
|---|---|---|---|
| soldering time (second) | 10 | 30 | 60 |
| nickel undercoat | 30 | 50 | 70 |
| tin undercoat | 90 | 100 | 100 |
| silver undercoat | 90 | 100 | 100 |

As is obvious from the above experimental result, the nickel undercoat has poor soldering characteristics when the soldering time is short. Conversely, it is appreciated that the tin undercoat and the silver undercoat have soldering characteristics far superior to the nickel undercoat. Furthermore, there was observed no significant difference between the tin undercoat and the silver undercoat in soldering characteristics.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A laminated structure for electronic equipment, comprising:
a substrate (11) having a main surface;
an undercoat plating layer (13) made of a metal selected from the group consisting of tin, silver, cadmium, lead, zinc and bismuth, formed on the main surface of said substrate (11); and
a gold plating layer (14) formed on said undercoat plating layer (13).

2. The laminated structure for electronic equipment according to claim 1, wherein
said substrate (11) is a printed circuit board having copper foil (12) on the surface thereof.

3. The laminated structure for electronic equipment according to claim 1, wherein
said substrate (11) is an electronic component such as a chip component.

4. A laminated structure for electronic equipment, comprising:
a substrate (11) having a main surface;
an undercoat plating layer (13) made of a metal acting as an anticatalyst in electroless plating, formed on the main surface of said substrate (11); and
a gold coating (14) formed on said undercoat plating layer (13) by electroless plating.

5. The laminated structure for electronic equipment according to claim 4, wherein
said metal acting as an anticatalyst is a metal selected from the group consisting of tin, silver, cadmium, lead, zinc and bismuth.

6. A method of manufacturing a laminated structure for electronic equipment, comprising the steps of:
forming a plating layer (13) serving as an undercoat on a substrate (11), using a metal selected from the group consisting of tin, silver, cadmium, lead, zinc and bismuth; and
forming a gold coating (14) on said undercoat plating layer (13) by electroless plating.

7. The method of manufacturing a laminated structure for electronic equipment according to claim 6, wherein
the metal forming said undercoat plating layer (13) functions as an anticatalyst in said electroless plating.

8. A method of electroless gold plating, comprising the steps of:
forming a plating layer (13) serving as an undercoat on a substrate (11) using tin or silver; and
forming a gold coating (14) on said undercoat plating layer (13) by electroless plating.

9. The method of electroless gold plating according to claim 8, wherein
said substrate (11) is a printed circuit board having copper foil (12) on the surface thereof, and
said undercoat plating layer (13) is formed on said copper foil (12).

10. The method of electroless gold plating according to claim 8, further comprising the step of dipping said substrate (11) in catalyst-applying treating liquid after forming said undercoat plating layer (13), wherein
said step of forming the gold coating is performed after said step of dipping.

11. The method of electroless gold plating according to claim 10, wherein
said catalyst-applying treating liquid includes palladium chloride and hydrochloric acid.

12. A method of electroless gold plating, comprising the steps of:
forming a plating layer (13) serving as an undercoat on a substrate (11), using a metal acting as an anticatalyst selected from the group consisting of cadmium, lead, zinc and bismuth; and
forming a gold coating (14) on said undercoat plating layer (13) by electroless plating.
